# DEMANDE DE BREVET EUROPEEN

(11) **EP 1 445 801 A1**
(43) Date de publication de la demande: **11.08.2004**
(21) Numéro de dépôt: 04290256.9
(22) Date de dépôt: 30.01.2004
(51) Int. Cl.: H01L 27/08

(54) **Inductance intégrée et circuit électronique l'incorporant**

(30) Priorité: 07.02.2003 FR 0301467
(71) Demandeur: STMicroelectronics S.A., 92120 Montrouge (FR)
(72) Inventeur: Van Haaren, Bart, 38660 Le Touvet (FR); Clement, Cecile, 38920 Crolles (FR); Gloria, Daniel, 38000 Grenoble (FR)
(74) Mandataire: Verdure, Stéphane

(57) **Abrégé**

Une Inductance intégrée (1) comprend une première piste conductrice (2) sensiblement plane réalisée à la surface d'un substrat (3) et ayant une forme qui définit un nombre déterminé N de spires concentriques (4,5). Une première paire de points d'accès correspond aux deux extrémités respectives de ladite première piste conductrice (6,6'). En outre, au moins une seconde paire de points d'accès (7,7') distincts des points d'accès de la première paire, sont agencés au niveau de deux zones respectives (14,15) de la première piste conductrice (2).

## Description

La présente invention est relative aux inductances utilisées dans les composants électroniques intégrés.

Plus particulièrement, l'invention concerne une inductance intégrée sensiblement plane réalisée à la surface d'un substrat, comprenant une première piste conductrice ayant une forme qui définit un nombre déterminé N de spires concentriques, et comprenant une première paire de points d'accès correspondant aux deux extrémités respectives de ladite première piste conductrice.

Le coût de fabrication d'un circuit électronique intégré comportant une telle inductance intégrée est fortement lié au niveau d'intégration des éléments électroniques le constituant. Dans certaines applications, il est nécessaire de disposer de plusieurs valeurs d'inductance dans un même circuit intégré. Des inductances distinctes sont alors réalisées à la surface du substrat, chacune ayant une valeur d'inductance respective.

La présente invention a notamment pour but d'augmenter le niveau d'intégration du circuit intégré, et donc de permettre une réduction du coût de fabrication d'un tel circuit dans ce genre d'application.

A cet effet, un premier aspect de l'invention concerne une inductance intégrée du type précité qui comprend en outre au moins une seconde paire de points d'accès distincts des points d'accès de la première paire, et agencés au niveau de deux zones respectives de la première piste conductrice.

De la sorte, la première piste conductrice présente des valeurs d'inductance respectives entre chaque paire de points d'accès. Par exemple, si elle comporte deux paires de points d'accès, elle présente une première valeur d'inductance entre la première paire de points d'accès et une seconde valeur d'inductance entre la seconde paire de points d'accès. Une inductance selon l'invention permet ainsi de remplacer avantageusement deux inductances selon l'art antérieur, voire plus en augmentant le nombre de paires de points d'accès.

Dans un mode de réalisation avantageux, la forme de la première piste conductrice présente une symétrie axiale ayant pour axe de symétrie la médiatrice du segment formé par les points d'accès de la première paire de points d'accès.

De préférence, cet axe de symétrie de la première piste conductrice est en outre la médiatrice du segment formé par les points d'accès de la seconde paire de points d'accès.

Les portions de la première piste conductrice donnant la première valeur d'inductance, respectivement la première et la seconde valeurs d'inductance, présentent ainsi une géométrie symétrique à partir de leur paire de point d'accès respective. De telles valeurs d'inductance peuvent être utilisées dans des structures différentielles, par exemple un oscillateur ou un amplificateur différentiel.

De préférence, l'inductance intégrée comprend en outre une seconde piste conductrice sensiblement rectiligne, d'axe coïncidant avec l'axe de symétrie de la première piste conductrice, et reliée électriquement à la première piste conductrice en une zone correspondant au milieu de la longueur développée de ladite première piste conductrice, ainsi qu'un premier point d'accès supplémentaire correspondant à une première extrémité de la seconde piste conductrice.

Cette première extrémité, qui correspond alors au « point milieu » de la première valeur d'inductance, est par exemple disposée entre les points d'accès de la première paire de points d'accès (dans le plan de l'inductance intégrée), et de préférence au milieu.

Dans un mode de réalisation avantageux, l'inductance intégrée comprend en outre un second point d'accès supplémentaire correspondant à une seconde extrémité de la seconde piste conductrice.

Cette seconde extrémité, qui correspond au « point milieu » de la deuxième valeur d'inductance, est par exemple disposée entre les points d'accès de la seconde paire de points d'accès (dans le plan de l'inductance intégrée), et de préférence au milieu.

Dans un exemple de réalisation, les points d'accès de la seconde paire de points d'accès se trouvent respectivement aux environs du quart et des trois quarts de la longueur développée (dans le plan de l'inductance intégrée) de la première piste conductrice.

La valeur d'inductance entre les points d'accès de la première paire de points d'accès est alors proche du double de la valeur d'inductance entre les points d'accès de la seconde paire de points d'accès.

Dans des modes de réalisation préférés de l'invention, on peut éventuellement avoir recours en outre à l'une et/ou à l'autre des dispositions suivantes :
- les spires de la première piste conductrice sont polygonales.
- les spires de la première piste conductrice sont octogonales.

Un deuxième aspect de l'invention se rapporte à un circuit électronique intégré qui comprend une inductance intégrée selon le premier aspect.

Un troisième aspect de l'invention se rapporte à un circuit électronique intégré qui comprend une inductance intégrée selon le premier aspect et des moyens pour appliquer des courants en opposition de phase respectivement sur chacun des points d'accès de la première paire de points d'accès, et/ou des moyens pour appliquer des courants en opposition de phase respectivement sur chacun des points d'accès de la seconde paire de points d'accès, le premier point d'accès supplémentaire et/ou le second point d'accès supplémentaire étant porté à un potentiel électrique neutre, typiquement la masse.

D'autres caractéristiques et avantages de l'invention apparaîtront au cours de la description suivante d'une de ses formes de réalisation, donnée à titre d'exemple non limitatif, en regard des dessins joints.

Sur les dessins :
- la figure 1 est une vue de dessus d'un premier mode de réalisation d'une inductance intégrée selon l'invention ;

- la figure 2 est le schéma électrique correspondant d'une inductance intégrée selon l'invention ; et,
- la figure 3 est une vue de dessus d'un second mode de réalisation d'une inductance intégrée selon l'invention.

Sur les différentes figures, les mêmes références désignent des éléments identiques ou similaires.

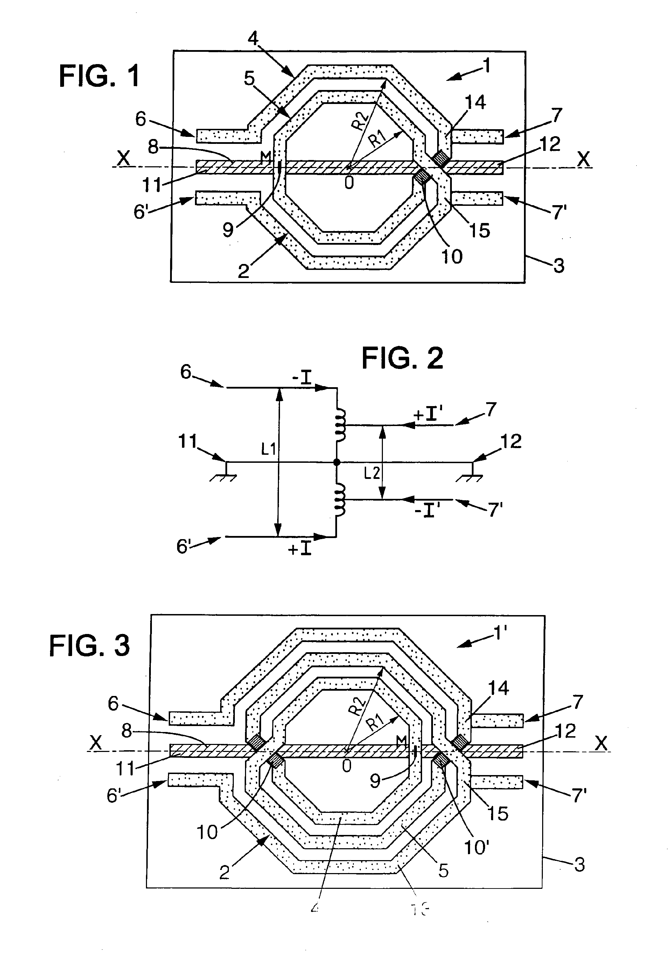

La figure 1 représente en vue de dessus une inductance intégrée 1, dans un premier mode de réalisation de l'invention. Cette inductance 1 est réalisée à la surface d'un substrat 3, selon les techniques connues de l'Homme du métier. L'inductance 1 est sensiblement plane. Par souci de simplicité, dans le présent exposé de l'invention, la géométrie de l'inductance 1 est décrite de façon bidimensionnelle en considérant un plan unique correspondant à la surface du substrat 3. Bien évidemment, différentes parties de l'inductance sont en général, et de façon connue en soi, réalisées dans des niveaux de métallisation respectifs.

L'inductance 1 comporte une première piste conductrice 2. Cette piste s'étend par exemple dans un niveau de métallisation déterminé (correspondant au plan de la figure), réalisé au-dessus d'un substrat semi-conducteur.

Dans l'exemple correspondant à la figure 1, la piste 2 forme deux spires concentriques 4 et 5 de centre O, de rayon respectivement R1 et R2. Ces rayons sont ici mesurés à partir du bord interne de la piste 2. Les spires sont de préférence de forme polygonale. Ici, elles sont de forme octogonale. De plus, la piste 2 présente une symétrie axiale par rapport à un axe X-X passant par le centre O des spires. Le passage de la spire 4 à la spire 5 sans contact entre les deux spires est assuré par l'insertion d'un pont à air 10 (ou "underpass"), dans un autre niveau de métallisation, qui est en dessous du plan de la figure dans l'exemple représenté mais qui peut aussi être au dessus de ce plan.

L'inductance 1 comporte une première paire de points d'accès 6 et 6' correspondant aux extrémités de la piste 2. De préférence, ces points sont disposés symétriquement de part et d'autre de l'axe X-X. La piste 2 présente une valeur d'inductance L1 entre la paire de points d'accès 6 et 6'.

L'inductance 1 comporte en outre une autre paire de points d'accès 7 et 7' agencés au niveau de deux zones respectivement 14 et 15 de la piste conductrice 2. La piste 2 présente une valeur d'inductance L2 entre les points d'accès 7 et 7'.

Dans l'exemple de réalisation de l'invention considéré, les points d'accès 7 et 7' sont disposés symétriquement de part et d'autre de l'axe X-X. Dit autrement, cet axe est aussi la médiatrice du segment formé par les points 7 et 7', en sorte que la géométrie de l'inductance 1 est symétrique par rapport à l'axe X-X'. De plus, les points 7 et 7' se situent respectivement aux environs du quart et des trois quarts de la longueur développée de la piste 2. Ainsi L1 est proche du double de L2.

L'inductance 1 peut en outre comporter une seconde piste 8 qui dans le mode de réalisation représenté, est rectiligne. La piste 8 est située dans l'exemple représenté dans un niveau de métallisation en dessous du plan de la figure 1. Si l'on considère globalement le plan de l'inductance 1, on peut dire que la piste 8 s'étend suivant l'axe X-X. En ce sens, on peut dire que l'axe longitudinal de la piste 8 coïncide avec l'axe X-X' de symétrie de la piste 2 dans le plan de celle-ci.

La piste 8 est reliée électriquement à la première piste 2 en une zone M correspondant au milieu de la longueur développée de la piste conductrice 2. Cette liaison électrique a lieu par exemple par l'intermédiaire d'une connexion électrique 9 (ou via) disposée perpendiculairement au plan de la piste 2. Cette zone M correspond donc au milieu de la portion de piste comprise entre les points d'accès 6 et 6', ainsi qu'au milieu de la portion de piste comprise entre les points d'accès 7 et 7'.

La seconde piste 8 comporte deux extrémités 11 et 12, dont l'une et/ou l'autre correspondent à des points d'accès supplémentaires respectifs de l'inductance 1. Ces points d'accès 11 et 12 sont disposés de telle sorte que la projection orthogonale du point d'accès 11 sur le plan de la piste 2 se situe entre et de préférence au milieu de la paire des points d'accès 6 et 6', et que la projection orthogonale du point d'accès 12 sur le plan de la piste 2 se situe entre et de préférence au milieu de la paire des points d'accès 7 et 7'.

La figure 2 représente un schéma électrique équivalent à une utilisation en mode différentiel des valeurs d'inductance L1 et L2 de l'inductance 1. On rappelle que l'inductance 1 présente, entre les points d'accès 6 et 6', la valeur d'inductance L1 et un point d'accès milieu 11. Elle présente également entre les points d'accès 7 et 7' une valeur d'inductance L2 et un point d'accès milieu 12. Ces points d'accès milieux 11 et 12 sont typiquement reliés à un potentiel neutre tel que la masse et on applique des courants +l et -l en opposition de phase respectivement sur chacun des points d'accès 6 et 6', et des courants +l' et -l' en opposition de phase respectivement sur chacun des points d'accès 7 et 7'.

Une inductance intégrée du type de l'inductance représentée sur les figures 1 et 2 et décrite ci-dessus, avec la valeur d'inductance L1 supérieure à la valeur d'inductance L2, peut par exemple être utilisée pour réaliser un circuit intégré de type VCO (de l'anglais "Voltage Controlled Oscillator") multibande en mode différentiel, équivalent à deux VCO à des fréquences différentes (environ doubles ici), par exemple 1,8 GHz et 0,9 GHz.

Ainsi l'invention permet effectivement d'augmenter le niveau d'intégration d'un circuit intégré et donc de réduire le coût de fabrication d'un tel circuit.

La figure 3 représente en vue de dessus une inductance intégrée 1' selon un autre mode de réalisation de l'invention. L'inductance 1' représentée en figure 3 diffère de l'inductance 1 représentée en figure 1 en ce que la piste 2 comporte non pas deux spires mais trois spires concentriques 4, 5 et 13, ici de forme octogonale. Le passage de la piste 2 de la spire 4 à la spire 5 sans contact entre les deux spires est assuré par l'insertion d'un pont à air 10. De la même façon, le passage de la piste 2 de la spire 5 à la spire 3 sans contact entre les deux spires est assuré par l'insertion d'un pont à air 10'. Ces ponts à air 10 et 10' sont situés dans d'autres niveaux de métallisation, qui sont en dessous du plan de la figure dans l'exemple représenté, mais qui peuvent aussi être au dessus.

L'inductance 1' comporte toujours une première paire de points d'accès 6 et 6' correspondant aux extrémités de la piste 2 et disposés symétriquement de part et d'autre de l'axe X-X. La piste 2 présente une valeur d'inductance L1 entre la paire de points d'accès 6 et 6'.

L'inductance 1' comporte toujours une autre paire de points d'accès 7 et 7' agencés au niveau de deux zones respectivement 14 et 15 de la piste conductrice 2. La piste 2 présente une valeur d'inductance L2 entre les points d'accès 7 et 7'.

Dans l'exemple de réalisation de l'invention considéré sur la figure 3, les points d'accès 7 et 7' sont toujours disposés symétriquement de part et d'autre de l'axe X-X. Cependant, ils se situent respectivement aux environs du cinquième et des quatre cinquièmes de la longueur développée de la piste conductrice 2. Ainsi la valeur d'inductance L2 est proche des trois cinquièmes de la valeur d'inductance L1.

Comme dans le cas de l'inductance 1 représentée en figure 1, l'inductance 1' comporte en outre, une seconde piste 8 qui comporte deux extrémités correspondant à deux points d'accès supplémentaires 11 et 12, disposés de la même façon que dans le cas de la figure 1. La piste 8 est reliée électriquement par une connexion électrique 9 au centre de la piste conductrice 2 en une zone M qui correspond au milieu de la portion de piste comprise entre les points d'accès 6 et 6', ainsi qu'au milieu de la portion de piste comprise entre les points d'accès 7 et 7'.

## Revendications

1. Inductance intégrée (1) sensiblement plane réalisée à la surface d'un substrat (3), comprenant une première piste conductrice (2) ayant une forme qui définit un nombre déterminé N de spires concentriques (4,5), et comprenant une première paire de points d'accès correspondant aux deux extrémités respectives de ladite première piste conductrice (6,6'),
**caractérisé en ce qu'**elle comprend en outre au moins une seconde paire de points d'accès (7,7') distincts des points d'accès de la première paire, et agencés au niveau de deux zones respectives (14,15) de la première piste conductrice (2).

2. Inductance intégrée (1) selon la revendication 1, **caractérisé en ce que** la forme de la première piste conductrice (2) présente une symétrie axiale d'axe déterminé (X-X), ledit axe déterminé étant la médiatrice du segment formé par les points d'accès (6,6') de la première paire de points d'accès.

3. Inductance intégrée (1) selon la revendication 2, **caractérisé en ce que** ledit axe de symétrie (X-X) de la première piste conductrice (2) est en outre la médiatrice du segment formé par les points d'accès (7,7') de la seconde paire de points d'accès (7,7').

4. Inductance intégrée (1) selon la revendication 2 ou la revendication 3, **caractérisé en ce qu'**elle comprend en outre une seconde piste conductrice (8) sensiblement rectiligne, d'axe coïncidant avec l'axe de symétrie de la première piste conductrice (2), et reliée électriquement à la première piste conductrice (2) en une zone (M) correspondant au milieu de la longueur développée de ladite première piste conductrice (2), ainsi qu'un premier point d'accès supplémentaire (11) correspondant à une première extrémité de la seconde piste conductrice (8).

5. Inductance intégrée (1) selon la revendication 4, **caractérisé en ce qu'**elle comprend en outre un second point d'accès supplémentaire (12) correspondant à une seconde extrémité de la seconde piste conductrice (8).

6. Inductance intégrée (1) selon l'une quelconque des revendications précédentes, **caractérisé en ce que** les points d'accès (7, 7') de la seconde paire de points d'accès se trouvent respectivement aux environs du quart et des trois quarts de la longueur développée de la première piste conductrice (2).

7. Inductance intégrée (1) selon l'une quelconque des revendications précédentes, **caractérisée en ce que** les spires (4,5) de la première piste conductrice sont polygonales.

8. Inductance intégrée selon la revendication 7, **caractérisée en ce que** les spires (4,5) de la première piste conductrice sont octogonales.

9. Circuit électronique intégré **caractérisé en ce qu'**il comprend une inductance intégrée (1) selon l'une quelconque des revendications précédentes.

10. Circuit électronique intégré **caractérisé en ce qu'**il comprend une inductance intégrée (1) selon l'une quelconque des revendications 4 à 8, et des moyens pour appliquer des courants (+l,-l) en opposition de phase respectivement sur chacun des points d'accès (6,6') de la première paire de points d'accès, et/ou des moyens pour appliquer des courants (+l',-l') en opposition de phase respectivement sur chacun des points d'accès (7,7')de la seconde paire de points d'accès, le premier point d'accès supplémentaire (11) et/ou le second point d'accès supplémentaire (12) étant porté à un potentiel électrique neutre.
